# EUROPEAN PATENT APPLICATION

(11) **EP 3 550 611 A1**
(43) Date of publication of application: **09.10.2019**
(21) Application number: 18305408.9
(22) Date of filing: 06.04.2018
(51) Int. Cl.: H01L 31/0224, H01L 31/18

(54) **METHOD FOR MANUFACTURING A PHOTOVOLTAIC DEVICE**

(71) Applicant: Total Solar International, 92400 Courbevoie (FR)
(72) Inventor: JAFFRENOU, Perine, 92400 Courbevoie (FR); SMITH, David, 92400 Courbevoie (FR); HARDERE, Nils-Peter, 92400 Courbevoie (FR); POULAIN, Gilles, 92400 Courbevoie (FR)
(74) Representative: Croonenbroek, Thomas Jakob

(57) **Abstract**

The invention relates to a method for manufacturing a photovoltaic device (15) having electrical front contacts (11), comprising the steps:
• providing a mono- or multi-crystalline silicon substrate (1) comprising a predetermined quantity of a p-type or a n-type dopant and having a front surface (3) and a back surface (5),
• forming an oxide layer (7) on the front surface of the substrate,
• depositing silicon on the oxide layer in a thick layer of 60 to 300nm on portions of the front surface to be equipped with metallic contacts (11) to create diffusion buffers (8) for metallic atoms, and in a thin layer (9) of 5 to 30nm on the whole front surface to create a passivation layer in combination with the oxide layer,
• annealing the oxide layer and the deposited silicon,
• forming metallic front contacts (11) on the diffusion buffers.

## Description

### FIELD OF INVENTION

The invention relates to a method for manufacturing a photovoltaic device, in particular for manufacturing a front contact photovoltaic device.

### BACKGROUND AND PRIOR ART

Photovoltaic devices with front contacts are well known in the art. For example US20050189015, US20110139230 and US6091021 disclose silicon wafer based photovoltaic devices including a front contacts or front electrodes. By convention, a front side or surface of a photovoltaic device is the side through which the sunlight penetrates for generation of an electrical current by the photovoltaic effect at the p-n / n-p junction of the photovoltaic device. The backside or back-surface of the photovoltaic device is the side opposite to the front side.

Typically, the front electrical contacts are made of metal deposited in openings or trenches manufactured in one or more passivation layers. The trenches can be created using wet etching with a serigraphed or ink-jet printed acid or alkaline solution or paste, and the metal is added in the openings, or the trenches are created at the same time with the contact formation by means of a chemical reaction between the constituents of a metal paste and the passivation layers.

Application technics of front electrical contacts may include in particular printing contacts by depositing a pattern using screen printing with pastes containing metallic particles, which are then heat-cured.

The curing of the electrical contacts requires heating of the cell, at temperatures generally over 400°C after the deposition, and followed by temperatures over 800°C for -for example- screen printed metal paste based contacts and annealing.

However, the heat treatment causes acute migration of metallic atoms in the silicon substrates which in turn causes increased recombination and therefore loss of efficiency of the photovoltaic device.

The front side of the photovoltaic device may also present a transparent insulation or passivation layer, which slows down surface recombination. This passivation layer should in particular cover the surface of the front side located between the electrical front contacts and should be as transparent as possible, for the sun light to reach the underlying surface of the semiconductor substrate.

Another example of a photovoltaic device with electrical front contacts is disclosed in Naber et al. « BBr3 Emitter Passivation by Ultra-thin Boron Doped LPCVD Polysilicon Layers » EUPVSEC Proceedings 2017.

Naber discloses a method for manufacturing a front contact photovoltaic device where a polycrystalline silicon layer of for example 110nm is applied to the front surface of the semiconductor substrate.

In a further process step, the polycrystalline silicon layer is thinned down during an etching step to a thickness of about 20nm except for the electrical front contact areas where the initial thickness is retained.

In between the electrical front contacts, the polycrystalline silicon layer is thin enough to show sufficient transparency features, e.g. with a transmission value greater than 80%, and in particular greater than 95%.

The increased thickness of the polycrystalline silicon layer in the regions of the electrical front contacts acts as a "diffusion buffer" during the metallisation step reducing therefore recombination due to metallic atom migration in the silicon substrate.

However, the depostion followed by the etching step for thinning down the initially thick polycrystalline silicon layer induces additional production costs. The etching can also damage the passivation layer stack, in case that the etching rate is not perfectly controlled across the entire solar cell surface so that a silicon oxide layer at the interface (thickness of 1 to 10nm) may be breached.

Thus, it will be appreciated that there exists a need in the art for an improved method for manufacturing sufficiently transparent polycrystalline silicon passivation layers with buffers against metal diffusion for efficient electrical front contacts for a photovoltaic.

### SUMMARY OF THE INVENTION

In order to overcome the aforementioned drawbacks the invention has for object a method for manufacturing a photovoltaic device having electrical front contacts, comprising the steps:
- providing a mono- or multi-crystalline silicon substrate comprising a predetermined quantity of a dopant and having a front surface and a back surface, said dopant comprising either a p-type dopant or a n-type dopant,
- forming an oxide layer on the front surface of the substrate,
- depositing silicon on the oxide layer:
   ∘ either first in a thick layer of 60 to 300nm, on portions of the front surface to be equipped with metallic contacts to create diffusion buffers for metallic atoms, then in a thin layer of 5 to 30nm on the whole front surface to create a passivation layer in combination with the oxide layer,
   ∘ or first in a thin layer of 5 to 30nm on the whole front surface to create a passivation layer in combination with the oxide layer, then in a thick layer of 60 to 300nm on portions of the front surface to be equipped with metallic contacts to create diffusion buffers for metallic atoms,
- annealing the oxide layer and the deposited silicon,
- forming metallic front contacts on the diffusion buffers for metallic atoms.

Since the thick polycrystalline silicon (thickness greater than 30nm) is only added locally on the portions to be metallized for realization of the electrical front contacts, an etching step of polycrystalline silicone can be avoided.

The process according to the invention may further have one or more of the following characteristics, taken separately or in combination.

The deposited silicon is amorphous silicon, nanocrystalline silicon or microcrystalline silicon.

The oxide layer is a silicon oxide layer, with a thickness comprised between 1 and 10nm.

The silicon deposited on portions of the front surface to be equipped with metallic contacts to form diffusion buffers is deposited using plasma enhanced chemical vapor deposition with patterned electrodes, which comprise protrusion and recesses forming spatially separated plasma chambers to selectively deposit the silicon on the portions of the front surface to be equipped with metallic contacts.

The silicon deposited on portions of the front surface to be equipped with metallic contacts to form diffusion buffers is deposited using printing of a silicon containing ink.

The deposited silicon is doped and the subsequent annealing step causes part of the dopant to migrate in the substrate.

The deposited silicon is not doped and a doped silicate glass is deposited on top of the silicon as dopant source during annealing step.

An antireflective coating is deposited on top of the passivation layer at least on the portions not to be covered by metallic contacts.

An opening is made by laser ablation in the antireflection coating on the portions to be covered by metallic contacts before forming the latter.

The front surface of the mono- or multi-crystalline silicon substrate is textured before forming of the oxide layer.

The diffusion buffers are formed with a thickness comprised between 60 and 150nm and the metal contacts are formed by deposition of a suspension or paste of metallic particles in a solvent and low temperature annealing of the metallic particles.

The diffusion buffers are formed with a thickness comprised between 150 and 300nm and the metal contacts are formed by high temperature annealing.

The width of the diffusion buffers is larger than the intended width of the metallic contacts, with an excess width greater than 2% and smaller than 10% of the intended width of the metallic contact on each side.

### BRIEF DESCRIPTION OF THE DRAWINGS

Other characteristics and benefits of the invention will appear in the following description based on the enclosed figures among which:
- figure 1 is a linear flow chart of the main steps of a first embodiment of the method according to the invention,
- figures 2 to 7 illustrate the main steps of the method in figure 1,
- figures 8 to 11 illustrate the main steps of a treatment for the back surface of the photovoltaic device.

### DETAILED DESCRIPTION

The embodiments described hereafter are given in an illustrating example and are not limited to them. The description refers to particular embodiments, but further embodiments can be obtained by combining or slightly altering features for example of two different embodiments. Said other embodiments are also within the scope of the invention. On all figures, the same reference applies to a single element or equivalent elements.

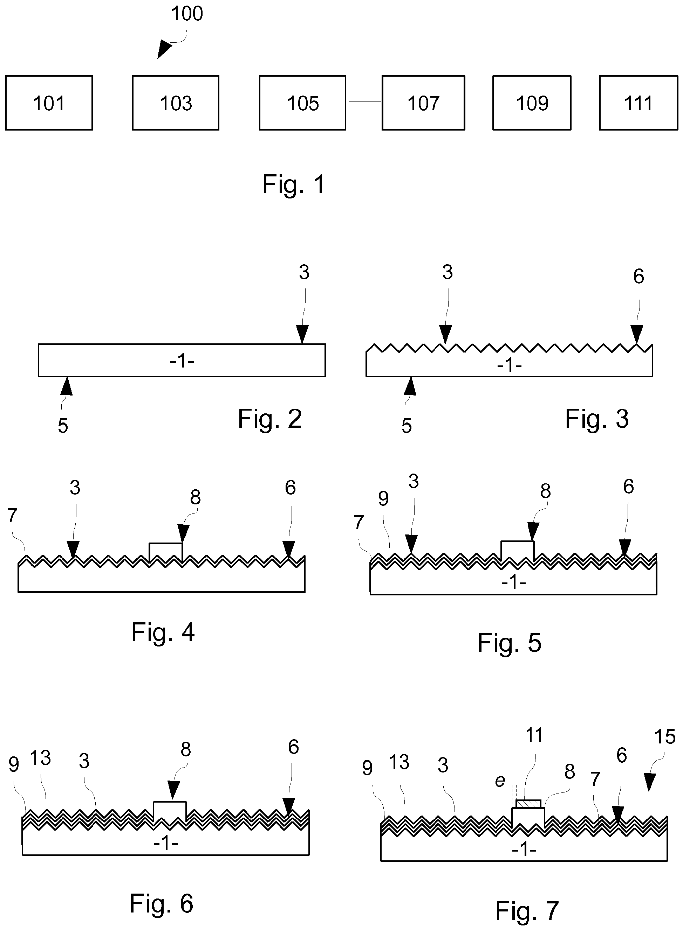

Figure 1 is a flow chart illustrating the main steps of a first embodiment of the method 100 for manufacturing a photovoltaic device 15 (see figure 7).

In a first step 101, a silicon substrate 1 is provided (see figure 2) having a front surface 3 and a back surface 5. The silicon substrate 1 is preferentially made of mono-crystalline silicon, but may also be made of multi-crystalline silicon.

As already stated, the front surface 3 is the face that is impacted first by the sunlight rays.

The silicon substrate 1 comprises a predetermined quantity of a dopant which is either a p-type dopant (like boron for example) or an n-type dopant (like phosphorus for example). The provided silicon substrate 1 has also undergone a saw damage removal process like wet chemical etching before application of the next processing steps.

In a second step 103, the front surface 3 of silicon substrate 1 is textured (see figure 3) for example with randomly distributed upright tetrahedral pyramids 6, which is called random texturing. The pyramids consist for example of four planes and four edges with an angle between the planes and the base of about 54,75°. Random texturing may be formed by submiting {100} silicon wafers to a lowly concentrated alkaline solution buffered with isopropyl alcohol (IPA) and containing dissolved silicon at elevated temperature.

The conditions are controlled in a way to ensure that the pyramids have for example a height between 1- 10µm. Texturing is illustrated on figure 3 by a saw-tooth profile of the front surface 3 for improved light trapping. However, other texturing methods may be used like for example in WO2011/023894 in the name of the applicant and enclosed by reference. Although generally realized on wafer to trap sunlight more efficiently, the texturing step is highly recommended with respect to the present invention but not necessary for its functioning.

In a third step 105 shown in figure 4, a thin layer of oxide 7, in particular silicon oxide, is grown or added on the front surface 3 of the substrate 1, either by adding silicon oxide, by chemical vapor deposition for example, or by oxidizing a top layer of the silicon substrate 1. The oxide layer 7 is for example 1 to 10nm thick, in particular 1 to 2,5nm.

A layer of polycrystalline silicon 9 is formed on the front surface 3 of the silicon substrate 1, on top of the oxide layer 7, on portions of the latter to be equipped with metallic contacts, to build diffusion buffers 8 for metallic atoms. The thickness of the polycrystalline silicon diffusion buffers 8 is comprised between 60 and 300nm. Such a metallic atom diffusion buffer 8 is represented in figure 4 on top of the oxide layer 7.

The polycrystalline silicon is only formed on portions of the front surface 3 to be equipped with metallic contacts 11, with the use, for example of a mask. The mask may show a pattern corresponding to a metallic contact pattern to be formed.

The polycrystalline silicon may in particular be deposited as amorphous silicon, and then annealed to obtain polycrystalline silicon. As an alternative, the deposited silicon may be nanocrystalline silicon, or microcrystalline silicon, and then annealed into polycrystalline silicon.

The diffusion buffers 8 can in particular be deposited by jet printing using cyclopentasilane or silicon nanoparticle containing inks, followed by annealing.

A particular embodiment foresees the use of plasma enhanced chemical vapor deposition (PECVD) using for example SiH₄ or SiH₂Cl₂ as precursor, with patterned electrodes for the generation of plasma. Suitable electrodes for depositing the amorphous or polycrystalline silicon specifically on the intended pattern of diffusion buffers 8 are described in EP2016070421, entitled "PLASMA GENERATING APPARATUS AND METHOD OF MANUFACTURING PATTERNED DEVICES USING SPATIALLY RESOLVED PLASMA PROCESSING" which is included by reference.

The patterned electrodes therein comprise recesses and protrusions facing the substrate 1. The voltage difference and working pressure are chosen so that the recesses and/or the protrusions form spatially isolated plasma chambers, under which the chemical deposition takes place on the substrate 1 in a spatially resolved way.

Using such patterned electrodes as described in EP2016070421 and the associated process, the amorphous or nano or microcrystalline silicon is selectively deposited or grown on the desired pattern. The patterned electrodes allow specifically to deposit silicon on the portions to be equipped with metallic contacts, while preserving the rest of the front surface 3.

As an alternative, amorphous silicon may be deposited by LPCVD (low pressure chemical vapour deposition) followed by a high temperature (900 to 1100°C) annealing step of the deposited amorphous silicon to form polysilicon.

As a further alternative, the third step 105 may comprise printing technology using silicon forming inks or pastes, with a controlled application of inks containing for example polysilane or neopentasilan oligomers, or a solution of silicon nanoparticles. The printing is then followed by annealing steps, using high or moderately high and high temperatures annealing (900°C and higher) to form polycrystalline silicon where ink or paste was deposited. A typical printing technology for pastes is screen printing, and ink jet printing is typically used for lower viscosity inks.

Then in a fourth step 107, additional silicon -for example amorphous silicon- is deposited on the entire front surface 3. The silicon deposited on the entire front surface 3 forms, after annealing into polysilicon a passivation layer 9 in combination with the thin oxide layer 7. Thus a thickness of 5-30nm can be reached outside the portions where the metallic contacts 11 are present and of 60-300nm beneath the metallic contacts 11.

The additional silicon may be deposited as amorphous, nanocrystalline or microcrystalline silicon, or directly as polycrystalline silicon if deposition conditions are right. However, the deposition of silicon as polycrystalline silicon is generally done at slower deposition rates, and is consequently longer.

In particular, during the third step 105 and with the help of a mask, amorphous, nanocrystalline, microcrystalline or polycrystalline silicon is deposited only on the front surface 3 on portions of the latter to be equipped with metallic contacts 11, to reach a thickness of 30-270nm, corresponding in particular to the desired thickness of the diffusion buffers 8, minus the intended thickness of the polysilicon layer of the uniform layer 9.

Polysilicon is then formed by annealing the deposited amorphous, nanocrystalline or microcrystalline silicon, for example at a temperature between 900 and 1100°C. The silicon deposited on the portion of the front surface 3 to be equipped with metallic contacts to form the diffusion buffers 8 and the additional silicon deposited on the whole front surface to form the uniform silicon layer 9 may be annealed during a single, common annealing step.

If the silicon is deposited as polycrystalline silicon, the annealing step will serve to bond the oxide layer 7, the uniform silicon layer 9 and the diffusion buffers 8, in particular creating an efficient passivation layer.

In the case where doped silicon is deposited to form the diffusion buffers 8 and/or the uniform silicon layer 9, the annealing step does not only form the polycrystalline silicon, but also allows the activation and diffusion of the dopants into the silicon substrate 1. The doped silicon therefore serves also as doping source during annealing step.

An alternative embodiment of the method 100 is easily derived by first depositing silicon to form the uniform silicon layer 9, and then silicon on the portion of the front surface 3 to be equipped with metallic contacts to form diffusion buffers 8. The following annealing step of the deposited silicon forming both the uniform polycrystalline silicon layer 9 and the polysilicon diffusion buffers 8 ensures bonding between the two in either case.

In case of Low Pressure Chemical Vapor Deposition of the silicon, the latter may not be doped and a further layer for example of doped silicate glass like borosilicate glass (BSG) or phosphosilicate glass (PSG) may be deposited on top of the silicon in order to serve as doping source during high temperature annealing.

In the preferred embodiment, the passivation layer comprises a layer of polycrystalline silicon which is deposited in a thin and uniform layer over the front surface 3, with the same technique as the diffusion buffers 8. The layer of polycrystalline silicon is then obtained by first depositing doped or non-doped silicon followed by annealing at a temperature between 900°C and 1100°C.

The obtained passivation layer 9 has for example a thickness comprised between 5 and 30nm, preferably 5 to 30nm, in particular around 5-20nm, and preferably 7-15nm. This thickness is sufficient to slow down surface recombination, while the passivation layer 9 remains sufficiently transparent for the obtained photovoltaic device to have a good efficiency.

In case the passivation layer 9 is only formed on the front surface 3 on portions of the latter not to be equipped with metallic contacts 11, a mask may be used, aligned for example using alignment on the edges of the substrate 1.

In case the passivation layer 9 comprises at least one additional layer of passivation material, different from polycrystalline silicon of the polysilicon passivation layer 9, it may be chosen in particular among the following group of passivation materials silicon nitride, silicon carbide, silicate glass, silicon oxide.

The passivation layer 9 may comprise several sub-layers of different materials (e.g. SiN, SiC, silicate glass). The total thickness of the multi-layered passivation layer 9 may be around or under 30nm.

In this embodiment, sub-layers of the passivation layer 9 may in particular be obtained by sputtering or chemical vapor deposition (CVD).

In a fifth step 109 shown in figure 6, an antireflective coating 13 (ARC) for example of silicon nitride SiN may be deposited on top of the passivation layer 9 at least on the portions not to be covered by metallic contacts 11.

In case the antireflective coating 13 also covers the diffusion buffers 8, an opening may be made through the antireflective coating 13 by laser ablation or etching on the portions to be covered by metallic contacts 11 before forming the latter.

In a sixth step 111 shown in figure 7, metallic front contacts 11 are formed on the diffusion buffers 8 for metallic atoms to obtain the photovoltaic device 15 (in figure 7, only the upside part of the photovoltaic device 15 is shown).

The sixth step 111 may be carried out by deposition of a suspension or paste of metallic particles in a solvent and low temperature drying and annealing of the metallic particles, or by depositing the electrical contacts 11 using chemical vapor deposition and annealing at lower temperature values (400°C to 800°C). In this case, the diffusion buffers 8 can be formed with a reduced thickness comprised between 60 and 150nm.

Alternatively, the metal front contacts 11 may be formed by high temperature annealing (900°C and above) in which case the diffusion buffers are formed with a thickness comprised between 150 and 300nm to prevent the deeper penetration of metallic atoms at higher temperatures.

In figure 7, it is possible to see that the diffusion buffers 8 are larger than the metallic contact 11, in particular with, in case of a centered metallic contact 11, an excess width e on each side. The excess width e is in particular taken proportional to the expected alignment error values of the apparatus used to deposit the metallic contacts 11.

The excess width e consequently accounts for possible alignment errors. The excess width e is in particular chosen as a compromise: making it small frees more front surface 3 to generate additional active irradiated surface, while making it large ensures that the metallic contacts are correctly placed on top of the diffusion buffers 8, even if the alignment is faulty.

In particular, an excess width e with a value greater than 2% and smaller than 10% of the intended width of the metallic contact 11 accounts for most alignment errors, while only slightly impairing the overall energy efficiency.

As an alternative to create the metallic front contacts 11, photoreactive silver or metal (nickel Ni, copper Cu, aluminum Al) containing material may be applied in a uniform layer or stack of layers. During an activation step, the photoreactive material is irradiated (for example with ultraviolet light) using a negative or positive mask, which renders respectively and selectively either the masked or unmasked portion of the photoreactive material susceptible to etching. In a subsequent etching step, the desired portion of the initially uniform photoreactive material layer is then etched away.

Other treatments may then be used to render the silver or metal in the remaining photoreactive material conducting, and/or additional metal may be electroplated, the preserved photoreactive material containing metal being used as a seed.

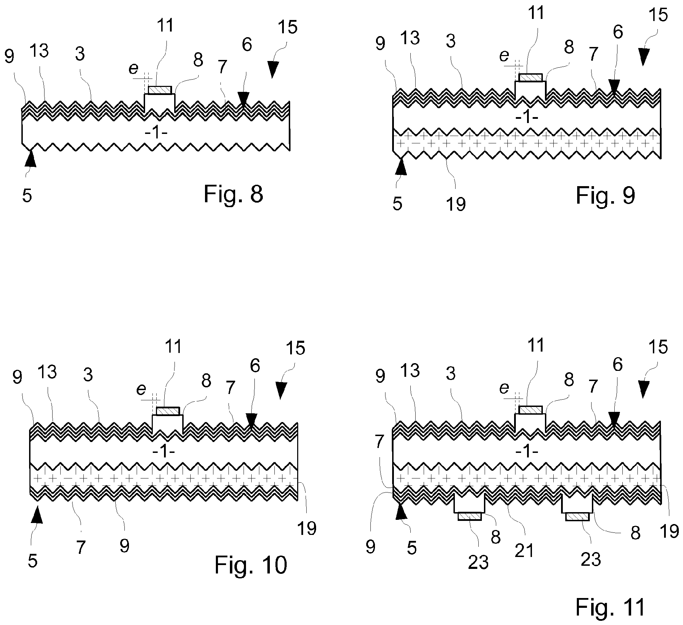

The figures 8 to 11 illustrate a possible treatment for the rear surface of the photovoltaic device 15.

The rear surface 5 is at first also textured, for example using the random pyramid method as illustrated in figure 3 in the case of the front surface 3. The random texturing may be performed as indicated in the case of the front surface (low concentration alcaline solution), in particular with similar temperature, concentration and timing parameters.

In figure 8, the back surface 5 is textured in a similar fashion than the front surface 3.

A thick layer of doped polycrystalline silicon 19 is then applied to the textured rear surface 5, as depicted in figure 9. The dopant contained in the thick polycrystalline silicon layer 19 is p-type in case of a n-type doped substrate 1, and n-type in case of a p-type doped substrate 1. The doped thick polycrystalline silicon layer 19 creates the junction at the back, where considerations about transparency are less important.

The back surface then undergoes the same treatment as the front surface 3. In figure 10, the back surface 5 is covered with a uniformly thick deposited silicon layer 9. In figure 11, diffusion buffers 8 are formed on the back surface 5.

The back surface 5 is then covered in a back surface antireflection coating 21 ("BARC" see figure 10). The back surface anti reflection coating 21 is for example silicon nitride SiN, silicon carbide SiC or silicate glass. The back surface antireflection coating 21 may also serve as passivation layer, or an additional, dedicated passivation layer may be implemented. The back surface antireflection coating 21 may in particular be a stack of several layers.

The back surface anti reflection coating 21 is then opened and metallic back contacts 23 are deposited on the back surface diffusion buffers 8, as depicted in figure 11. The back contacts 23 are possibly deposited using the same methods as described for the front contacts 11.

Other embodiments can be obtained wherein the back surface is not textured. In such processes, the back surface antireflection coating 21 is even more indicated.

The steps to form the junction and back surface 5 treatment are here presented as performed sequentially after the steps of the method 100 to obtain the front surface 3. However, steps performed on the front surface 3 and steps performed on the back surface 5 can be done in an alternating or simultaneous fashion, in particular when similar atmosphere, vacuum, temperature and/or alignment conditions are used.

For example, the step 101 of random texuring of the front surface may be performed at the same time and in the same bath as the step of texturing the back surface 5.

Thanks to the method according to the invention, no specific etching step of an initially thick passivation layer 9 is required.

## Claims

1. Method for manufacturing a photovoltaic device (15) having electrical front contacts (11), comprising the steps:
• providing a mono- or multi-crystalline silicon substrate (1) comprising a predetermined quantity of a dopant and having a front surface (3) and a back surface (5), said dopant comprising either a p-type dopant or a n-type dopant,
• forming an oxide layer (7) on the front surface (3) of the substrate (1),
• depositing silicon on the oxide layer (7):
∘ either first in a thick layer of 60 to 300nm, on portions of the front surface (3) to be equipped with metallic contacts (11) to create diffusion buffers (8) for metallic atoms, then in a thin layer (9) of 5 to 30nm on the whole front surface (3) to create a passivation layer in combination with the oxide layer (7),
∘ or first in a thin layer (9) of 5 to 30nm on the whole front surface (3) to create a passivation layer in combination with the oxide layer (7), then in a thick layer of 60 to 300nm on portions of the front surface (3) to be equipped with metallic contacts (11) to create diffusion buffers (8) for metallic atoms,
• annealing the oxide layer (7) and the deposited silicon,
• forming metallic front contacts (11) on the diffusion buffers (8) for metallic atoms.

2. Method according to claim 1, wherein the deposited silicon is amorphous silicon, nanocrystalline silicon or microcrystalline silicon.

3. Method according to claim 1 or 2, wherein the oxide layer (7) is a silicon oxide layer, with a thickness comprised between 1 and 10nm.

4. Method according to claim 1, 2 or 3, wherein the silicon deposited on portions of the front surface (3) to be equipped with metallic contacts (11) to form diffusion buffers (8) is deposited using plasma enhanced chemical vapor deposition with patterned electrodes, which comprise protrusions and recesses forming spatially separated plasma chambers to selectively deposit the silicon on portions of the front surface (3) to be equipped with metallic contacts (11).

5. Method according to claim 1, 2 or 3, wherein the silicon deposited on portions of the front surface (3) to be equipped with metallic contacts (11) to form diffusion buffers (8) is deposited using printing of a silicon containing ink.

6. Method according to any of the preceding claims, wherein the deposited silicon is doped and the subsequent annealing step causes part of the dopant to migrate in the substrate (1).

7. Method according to any of claims 1 to 5, wherein the deposited silicon is not doped and a doped silicate glass is deposited on top of the deposited silicon as dopant source during annealing step.

8. Method according to any of claims 1 to 7, wherein an antireflective coating (13) is deposited on top of the passivation layer (9) at least on the portions not to be covered by metallic contacts (11).

9. Method according to claim 8, wherein an opening is made by laser ablation in the antireflection coating (13) on the portions to be covered by metallic (11) contacts before forming the latter.

10. Method according to any of claim 1 to 9, wherein the front surface (3) of the mono- or multi-crystalline silicon substrate is textured before deposition of the oxide layer 7.

11. Method according to any of the preceding claims, wherein diffusion buffers (8) are formed with a thickness comprised between 60 and 150nm and the metal contacts (11) are formed by deposition of a suspension or paste of metallic particles in a solvent and low temperature annealing of the metallic particles.

12. Method according to any of claim 1 to 11, wherein diffusion buffers (8) are formed with a thickness comprised between 150 and 300nm and the metal contacts (11) are formed by high temperature annealing.

13. Method according to any of claim 1 to 12, wherein the width of the diffusion buffers (8) is larger than the intended width of the metallic contacts (11), with an excess width (e) greater than 2% and smaller than 10% of the intended width of the metallic contact (11) on each side.
